(19) **Europäisches Patentamt**

**European Patent Office**

**Office européen des brevets**

(11) **EP 0 793 861 B1**

(12) **EUROPÄISCHE PATENTSCHRIFT**

(45) Veröffentlichungstag und Bekanntmachung des Hinweises auf die Patenterteilung:
**21.10.1998 Patentblatt 1998/43**

(51) Int Cl.$^6$: **H01L 45/00**

(21) Anmeldenummer: **95938454.6**

(22) Anmeldetag: **20.11.1995**

(86) Internationale Anmeldenummer:
**PCT/EP95/04565**

(87) Internationale Veröffentlichungsnummer:
**WO 96/16448 (30.05.1996 Gazette 1996/25)**

(54) **TUNNEL-EFFEKT BAUELEMENT UND VERFAHREN ZU SEINER HERSTELLUNG**

TUNNEL-EFFECT COMPONENT AND METHOD OF MANUFACTURING THEREOF

COMPOSANT A EFFET TUNNEL ET SON PROCEDE DE REALISATION

(84) Benannte Vertragsstaaten:
**AT BE CH DE DK ES FR GB GR IE IT LI LU MC NL PT SE**

(30) Priorität: **22.11.1994 DE 4441502**

(43) Veröffentlichungstag der Anmeldung:
**10.09.1997 Patentblatt 1997/37**

(73) Patentinhaber: **AMO GMBH**
**52074 Aachen (DE)**

(72) Erfinder:
• **ALTMEYER, Stefan**
**D-52070 Aachen (DE)**

• **SPANGENBERG, Bernd**
**D-52070 Aachen (DE)**
• **KURZ, Heinrich**
**D-52076 Aachen (DE)**

(74) Vertreter: **Cohausz & Florack**
**Patentanwälte**
**Kanzlerstrasse 8a**
**40472 Düsseldorf (DE)**

(56) Entgegenhaltungen:
**EP-A- 0 181 191**      **EP-A- 0 493 258**

## Beschreibung

Die Erfindung betrifft ein Tunneleffekt-Bauelement und ein Verfahren zu seiner Herstellung. Insbesondere betrifft die Erfindung Einzelelektronen-Tunnelbauelemente sowie Quasiteilchen-Tunnelbauelemente und Verfahren zu deren Herstellung.

Ein Tunneleffekt-Bauelement mit zwei auf einem Substrat ausgebildeten leitfähigen Bereichen und einer räumlich dazwischen liegenden isolierenden Schicht ist aus der EP-A-0 496 259 in Form eines sogenannten Josephson-Kontaktes bekannt. Bei diesem Bauelement sind die leitfähigen Bereiche supraleitend.

Auf dem Prinzip des Tunneleffekts beruhende Bauelemente sind prinzipiell aus dem Stand der Technik bekannt (H. Grabert und M. H. Devoret, Physikalische Blätter, 50, p. 229 ff. (1994)). Bei solchen auf dem Tunneleffekt beruhenden Bauelemente werden die leitfähigen Bereiche durch aufgedampfte Metallfilme in der Größenordnung von einigen nm realisiert, zwischen denen eine Oxidbarriere besteht. Die Schalteigenschaften eines solchen Bauelementes ergeben sich durch ein kontrolliertes Tunneln eines Elektrons durch die Oxidbarriere zwischen den leitfähigen Bereichen, wobei zur Ausbildung z.B. eines sog. "Einzelelektronentunneltransistors" zwei solche Tunnelkontakte erforderlich sind.

Das Verfahren zur Herstellung eines solchen Bauelementes ist als "Sandwich-Verfahren" bekannt. Hierdurch wird zunächst eine Metalleiterbahn auf ein Substrat aufgebracht, die anschließend durch gezielte Oxidation isolierend wird. Anschließend wird kreuzend zur ersten Leiterbahn eine zweite Leiterbahn aufgebracht, wobei im Kreuzungsbereich ein Tunnelkontakt gebildet wird.

Die Herstellung eines solchen bekannten Tunneleffekt-bauelementes erfolgt beispielsweise mit einer sogenannten "Schrägschatten"-Bedampfungstechnik (J. Niehmeyer, PTB-Mitteilungen 84 (1974), S. 251), bei der während zweier aufeinanderfolgender Bedampfungen eines Substrates aus Aluminium unter verschiedenen Winkeln durch eine über dem Substrat mit Abstand angebrachte Maske die beiden leitfähigen Bereiche erzeugt werden. Dabei wird nach dem ersten Bedampfungsschritt der dabei entstandene Metallstreifen durch Zugabe von Sauerstoff thermisch oxidiert. Durch das teilweise Überlappen des beim nachfolgenden Bedampfungsschritt hergestellten Metallstreifens mit dem zunächst ausgebildeten Metallstreifen bildet sich dann ein Tunnelkontakt, dessen Abmessungen typischerweise 50 nm x 50 nm betragen. Dieses Verfahren ist herstellungstechnisch aufwendig, da die "hängende Maske" vor den beiden Bedampfungsschritten lithographisch hergestellt werden muß.

Schließlich ist aus M. Goetz et al, "Preparation of self-aligned in-line tunnel junctions for applications in single-charge electronics", J. Appl. Phys. 78(9), 1. November 1995 ein anderes Verfahren zur Herstellung eines Tunneleffekt-Bauelementes bekannt, bei der zunächst ein erster leitfähiger Bereich ausgebildet wird, dessen Stirnfläche oxidiert wird, und anschließend ein zweiter leitfähiger Bereich gebildet wird, dessen Stirnfläche mit derjenigen des ersten Bereichs fluchtet. Hierdurch wird zwischen den beiden Stirnflächen der Tunnelkontakt ausgebildet (sog. SAIL-Prozeß).

Ein wesentliches die Funktion des Tunneleffekt-Bauelementes bestimmendes Element ist die Kapazität des Tunnelkontaktes. Um eine Funktion des Elementes bei Temperaturen sicherstellen zu können, die oberhalb von nur im Labor erreichbaren Werten von einigen mK liegen, sind Kapazitäten von weniger als $10^{-18}$F erforderlich, damit die Einzelelektronen-Ladungsenergie der Tunnelkapazität hinreichend groß gegenüber der thermischen Energie ist.

Weiterhin muß zur Sicherstellung der Einzelelektronen-Ladungsdiskretisierung der Tunnelwiderstand des Tunnelkontaktes größer sein als der Quantenwiderstand, jedoch andererseits noch so begrenzt, daß eine meßtechnische Erfassung des Tunnelstroms möglich ist.

Nach den herkömmlichen Verfahren hergestellte Tunneleffekt-Bauelemente zeichnen sich dadurch aus, daß sich deren Kapazität im wesentlichen nach der einem Plattenkondensator entsprechenden Kapazität der sich gegenüberliegenden metallischen Flächen bestimmt. Beispielsweise ergibt sich bei dem "Sandwich-Verfahren" die Tunnelkapazität gemäß der Gleichung

$$C = \varepsilon_0 \varepsilon_r \frac{A}{d}$$

Bei Verwendung eines Materials mit hinreichend geringem Er läßt sich die Kapazität verringern durch Reduzierung der Fläche A und Erhöhung der Dicke d des Tunnelkontaktes. Allerdings führt eine Erhöhung der Dicke des Tunnelkontaktes zu einem exponentiellen Abfall des Tunnelstroms, so daß als wesentlicher Parameter für die Reduzierung der Tunnelkapazität die Fläche des Tunnelkontaktes verbleibt. Zum Erreichen einer hinreichend geringen Tunnelkapazität sind aber damit Leiterbahnbreiten von weniger als 7 nm erforderlich, die technologisch nur höchst aufwendig herstellbar sind.

Der Erfindung liegt davon ausgehend die Aufgabe zugrunde, ein Tunneleffekt-Bauelement bzw- ein Verfahren zu seiner Herstellung dahingehend weiterzuentwickeln, daß bei vertretbarem Herstellungsaufwand eine hinreichende Funktion des Elementes auch bei technisch handhabbaren Temperaturen gegeben ist.

Diese Aufgabe wird gemäß einer ersten Variante der Erfindung gelöst durch ein Tunneleffekt-Bauelement bestehend aus einem Substrat, einem isolierenden Bereich, der aus einer eine Tunnelbarriere bildenden Stufe einer Dicke auf dem Substrat besteht, wobei mindestens eine ebene Seitenfläche des stufenförmigen isolierenden Bereichs senkrecht zur Substratebene verläuft, und einer leitfähigen Schicht mit einer weiteren Dicke, bestehend aus mindestens zwei leitfähigen Bereichen, die räumlich voneinander durch einen durch Abstimmung der Dicken bestimmten, vom leitfähigen Material ausgesparten Abschnitt der mindestens einen Seitenfläche des isolierenden Bereichs voneinander getrennt sind.

Gemäß einer zweiten Variante der Erfindung wird diese Aufgabe gelöst durch ein Tunneleffekt-Bauelement bestehend aus einem Substrat, einem isolierenden Bereich, der aus einem eine Tunnelbarriere bildenden porösen Bereich einer Dicke auf dem Substrat besteht, wobei mindestens eine Seitenfläche des isolierenden porösen Bereichs im wesentlichen senkrecht zur Substratebene verläuft, und einer leitfähigen Schicht mit einer weiteren Dicke, bestehend aus mindestens zwei leitfähigen Bereichen, die räumlich voneinander durch einen durch Abstimmung der Dicken bestimmten, vom leitfähigen Material ausgesparten Abschnitt der mindestens einen Seitenfläche des isolierenden Bereichs voneinander getrennt sind.

Gemäß dem Herstellungsverfahren der eingangs genannten Art wird diese Aufgabe durch ein Verfahren gelöst, bei dem auf einen auf der Oberfläche eines Substrats ausgebildeten nichtleitenden Bereich die Aufbringung einer leitfähigen Schicht erfolgt, wobei mindestens zwei voneinander getrennte leitfähige Bereiche ausgebildet werden, die durch Abstimmung der Materialdicken des leitfähigen Aufbringungsmaterials einerseits bzw. des nichtleitenden Materials andererseits von einer im wesentlichen in Aufbringungsrichtung verlaufenden ebenen Seitenfläche des nichtleitenden Bereichs gegeneinander isoliert sind.

Die Erfindung zeichnet sich dadurch aus, daß der Tunnelkontakt einerseits einen im gewünschten Bereich liegenden Tunnelwiderstand aufweist, jedoch andererseits die Kapazität des Tunnelkontaktes um Größenordnungen gegenüber den bekannten Verfahren herabgesetzt werden kann. Dies ist daraus abzuleiten, daß es bei dem nach dem erfindungsgemäßen Verfahren hergestellten Bauelement im wesentlichen keine Überlappung von leitfähigen Bereichen im Sinne eines Plattenkondensators gibt. Vielmehr sind die wirksamen metallischen Flächen im Unterschied zum Stand der Technik in einer räumlich versetzten Weise zueinander angeordnet.

Dies erfolgt dadurch, daß sich beim Abscheiden des Leitermaterials auf das Substrat bzw. den isolierenden Bereich an dem sich in Aufbringungsrichtung erstreckenden Abschnitt des isolierenden Bereichs ein Kantenabriß des Metalles ergibt. Das erfindungsgemäße Verfahren macht sich dabei zunutze, daß die Einstellung von Schichtdicken beim Aufdampfen technologisch gut beherrschbar ist. Durch die geeignete Einstellung der Schichtdicken des isolierenden Materials einerseits und des leitfähigen Materials andererseits ist es somit möglich, eine sehr viel kleinere Tunnelkapazität auszubilden, ohne daß der technologische Aufwand hierfür steigt.

Gemäß einer ersten Variante der Erfindung wird das isolierende Material als Stufe auf einen ebenen Abschnitt des Substrats aufgetragen. Dabei verläuft die ebene Seitenfläche des nichtleitenden Bereichs im wesentlichen parallel zur Aufbringungsrichtung. Die im anschließenden weiteren Aufbringungsprozeß aufgetragene leitfähige Schicht weist dabei eine Materialdicke auf, die kleiner ist als die Länge (Höhe) der Seitenfläche des isolierenden Bereichs. Hierdurch ergibt sich der gewünschte Kantenabriß im Bereich der Seitenfläche automatisch. Das Verhältnis von Materialdicken im leitfähigen Bereich bzw. im nichtleitenden Bereich kann aber auch praktisch beliebig variiert werden, wenn nur gewährleistet ist, daß kein Zusammenwachsen der leitfähigen Schichten erfolgt. D.h. es muß auch bei abgerundeten Aufbringungsprofilen (aufgrund der Oberflächenspannung) durch entsprechende Einstellung der Dicken dafür gesorgt werden, daß stets ein isolierender Abschnitt verbleibt.

Gemäß einer zweiten Variante der Erfindung bildet das Substrat bei entsprechender Materialauswahl selbst den isolierenden Bereich, indem in der Substratoberfläche eine Vertiefung vorgenommen wird, die vorzugsweise durch Naß- oder Trockenätzen hergestellt wird. Die Kante dieser Vertiefung bildet den für den Tunnelvorgang wesentlichen isolierenden Bereich. Anschließend erfolgt wiederum der Aufbringungsschritt für das leitfähige Material. Hierbei dienen die Kanten der Vertiefung im Substrat als Abrißstelle. Auch bei dieser Variante läßt sich durch ensprechende Einstellung der Schichtdicke der leitfähiegn Schicht in der Vertiefung in Bezug auf die Höhe der Vertiefung eine entsprechende Dimensionierung des Bauelements erreichen.

In einer weiteren Ausgestaltung der Erfindung ist vorgesehen, daß im Falle einer unerwünschten Kantenbelegung mit metallischem Material dieses im Anschluß an die Aufbringung der leitfähigen Schicht entfernt wird. Die Entfernung kann dabei entweder durch Einspeisung eines kurzfristigen Kurzschlußstromes erfolgen, durch ein geeignetes Naß- oder Trockenätzverfahren oder durch chemische Modifikation (Oxidation, Nitrieren).

Bevorzugte Anwendung findet das erfindungsgemäße Verfahren zur Herstellung eines EinzelelektronenTunneltransistors. Dieses Verfahren setzt sich aus folgenden Schritten zusammen:

a) Aufdampfen eines isolierenden Bereichs vorzugsweise aus $Cr_2O_3$, auf ein Substrat, insbesondere hochohmiges Si,

b) Aufdampfen einer metallisch leitfähigen Schicht, insbesondere von metallischem Chrom, senkrecht zum isolierenden Bereich derart, daß an den jeweils gebildeten Grenzflächen ein Kantenabriß stattfindet und das auf der Barriere befindliche Chrom als "metallische Insel" verbleibt, wobei gleichzeitig ein als Gate-Elektrode wirkender leitfähiger Bereich in der Nachbarschaft des Inselbereichs ausgebildet wird.

c) Verbindung der Source- und Drainanschlüsse mit den beiden leitfähigen Bereichen und Ausführung eines weiteren, gleichzeitig aufgedampften leitfähigen Bereiches als Gateanschluß.

Bei einem solchen Bauelement läßt sich - vergleichbar mit einem Feldeffekttransistor - der Transportprozeß für die Ladungen über eine Steuerspannung beeinflussen.

Eine weitere bevorzugte Ausführungsform der Erfindung sieht vor, daß als isolierender Bereich eine Materialschicht aus porösem dielektrischem Material aufgebracht wird, welches eine schwammartige Struktur aufweist. Ein solcher "Untergrund" ermöglicht das anschließende Aufbringen einer relativ dicken und unzusammenhängenden Metallschicht, die leitende "Kügelchen" in den Poren des porösen Untergrundes bildet.

Eine solche technologische Gestaltung ermöglicht eine gegenüber dem Stand der Technik deutlich verbesserte Stromdichte durch das Bauelement. Beim Stand der Technik wurde im Unterschied dazu stets mit diskontinuierlichen metallischen Filmen gearbeitet, die durch Aufdampfen von sehr geringen Schichtdicken (3-5 nm) auf ebene dichte Substrate hergestellt wurden. Aufgrund der geringen Metallschichtdicke war die Stromtragfähigkeit eng begrenzt. Andererseits konnte eine Erhöhung der Schichtdicke nicht realisiert werden, da ansonsten das Tunneleffektverhalten ausschied.

Die Erfindung wird im folgenden anhand einer Zeichnung näher erläutert, dabei zeigen

Fig. 1-1c      Prinzipskizzen zur Erläuterung der Erfindung

Fig. 2a-2c      ein Ausführungsbeispiel für ein erstes Herstellungsverfahren gemäß der Erfindung

Fig. 3      ein Ausführungsbeispiel für ein zweites Herstellungsverfahren gemäß der Erfindung

Fig. 4      eine I/U Kennlinie zur Erläuterung der Funktion der Erfindung bei T=20 K und

Fig. 5      eine I/U Kennlinie bei T=1,8 K

Die in Fig. 1a dargestellte Prinzipskizze zur Erläuterung der Erfindung zeigt zunächst (gestrichelt) ein Substrat 1, welches aus Reinsilizium besteht und auf welches schrittweise mehrere Schichten aufgedampft werden. Die Aufdampfrichtung ist dabei durch den Pfeil dargestellt. In einem ersten Aufdampfprozeß wird nichtleitendes Material, z. B. $Cr_2O_3$, auf das ebene Substrat 1 aufgedampft, wobei die Materialdicke $d_2$ beträgt. Die

Struktur dieses aufgedampften nichtleitenden Bereichs 2 ist dabei so gestaltet, daß durch entsprechende Masken o. ä. eine sich in Aufbringungsrichtung erstreckende glatte Seitenfläche 2a ausgebildet wird.

Im anschließenden Aufdampfprozeß für metallisches Material scheidet sich eine Metallschicht sowohl direkt auf dem Substrat als auch auf dem nichtleitenden Bereich 2 ab. Die Metallschicht hat die Breite 1 und die Schichtdicke $d_1$, die geringer ist als die Schichtdicke $d_2$ des nichtleitenden Bereichs 2.

Wie aus Fig. 1a erkennbar ist, findet an der Seitenfläche 2a des isolierenden Bereichs 2 ein Kantenabriß des metallischen Films statt dahingehend, daß dort die metallische Schicht in zwei leitfähige Teilbereiche 3a,3b aufgetrennt wird. Hierdurch wird eine räumlich in Aufdampfrichtung versetzte Anordnung der beiden leitfähigen Bereiche 3a,3b erzeugt, wobei der Tunnelkontakt in dem Abschnitt der Seitenfläche 2a ausgebildet wird, welcher durch den Kantenabriß vom leitfähigen Aufbringungsmaterial ausgespart ist. Hierdurch ergibt sich einerseits eine äußerst geringe Tunnelkapazität in der Größenordnung von wenigen Atofarad (aF) und zum anderen durch die entsprechende Wahl des isolierenden Materials im Barrierenbereich ein Tunnelwiderstand, welcher einerseits wie verlangt sehr viel größer ist als der Quantenwiderstand, aber andererseits so klein, daß der Tunnelstrom meßtechnisch noch erfaßbar ist.

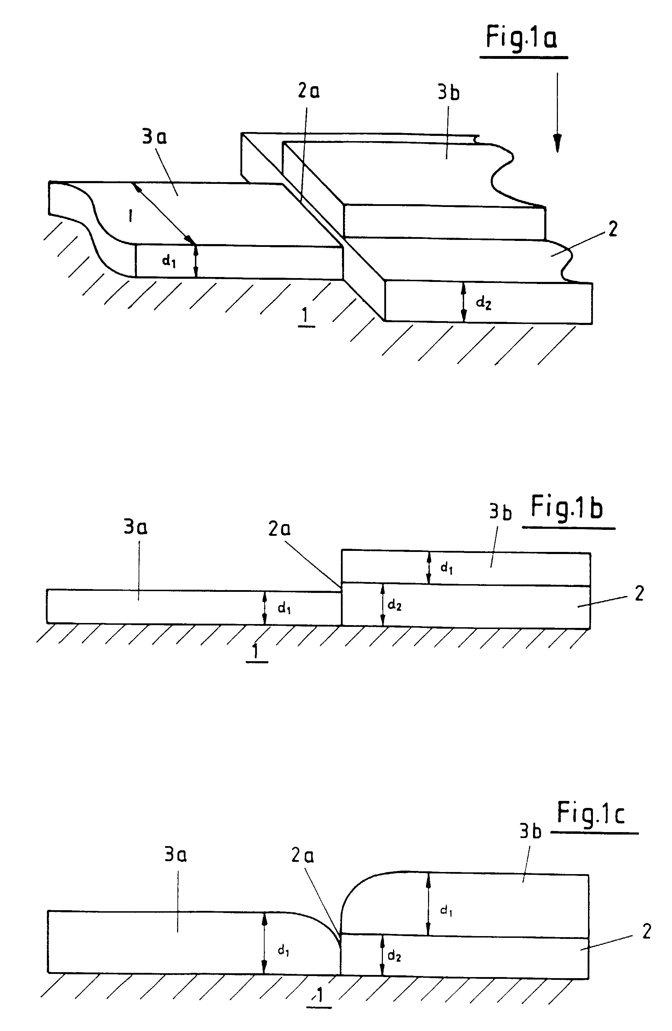

Fig. 1b zeigt die in Fig. 1a dargestellte Prinzipskizze im seitlichen Schnitt, wobei ersichtlich ist, daß die Dicke $d_1$ der metallischen Schicht kleiner ist als die Dicke $d_2$ des nichtleitenden Materials.

Fig. 1c zeigt im Unterschied zu Fig. 1b eine Darstellung, die sich ergibt, wenn bedingt durch Oberflächenspannungen das Aufdampfprofil nicht abgekantet sondern im Grenzbereich zwischen den metallischen Schichten 3a,3b abgerundet ist. Die Abrundung führt dazu, daß auch bei Schichtdicken $d_1$ des metallischen Materials, die größer sind als die Dicke $d_2$ des nichtleitenden Bereichs 2, sich ein vom leitfähigen Material ausgesparter Abschnitt 2a ausbildet, so daß ein erfindungsgemäßer Tunnelkontat realisiert wird.

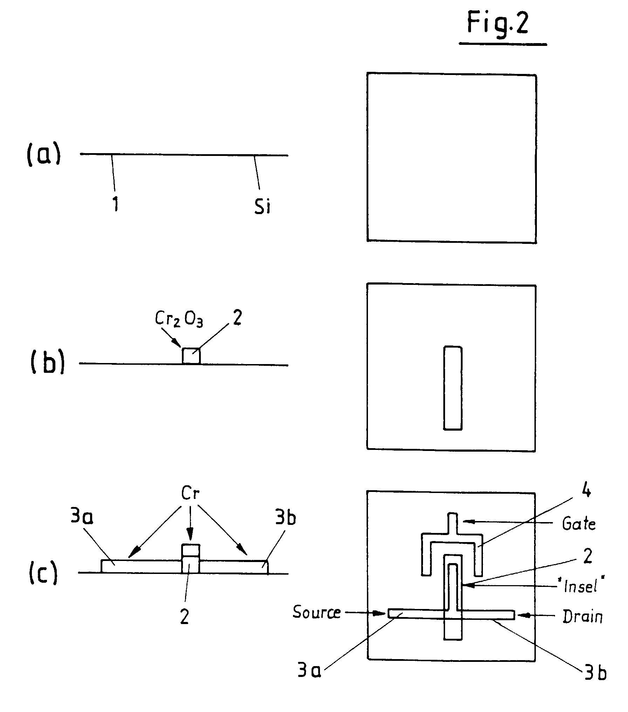

Fig. 2 zeigt ein erstes Ausführungsbeispiel der Erfindung zur Herstellung eines Einelektronen-Tunneltransistors.

Hierzu wird auf ein geeignetes Substrat 1, z. B. hochohmiges Si, gemäß Fig. 2b eine Bahn aus nichtleitendem dielektrischem Material, beispielsweise $Cr_2O_3$, in einer bestimmten Schichtdicke aufgetragen. Gemäß Fig. 2c erfolgt anschließend die Auftragung einer metallischen Schicht, z. B. Chrom. Die Richtung der Chrombahn ist dabei senkrecht zu derjenigen des $Cr_2O_3$, wie dies aus den rechten Teilen der Fig. 2b,2c hervorgeht. Durch die Kantenabrisse an beiden Seiten der isolierenden Mittelschicht werden zum einen die metallischen Bereiche 3a,3b voneinander getrennt. Zum anderen entsteht im mittleren isolierenden Bereich eine metallische Inselschicht.

In der Nähe der letztgenannten, metallischen Inselschicht wird gleichzeitig eine metallisch leitfähige Schicht aufgedampft, die später als Gateanschluß des so hergestellten Elektronen-Tunneltransistors dient. Die beiden leitfähigen Bereiche 3a,3b dienen für den Source- bzw. Drainanschluß.

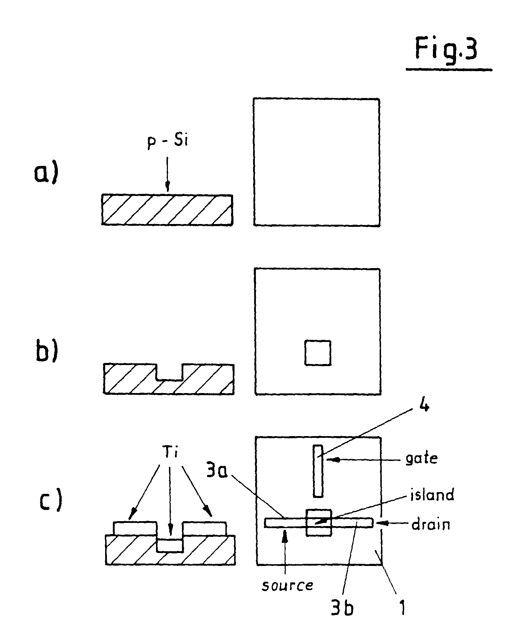

Das in Fig. 3 dargestellte zweite Ausführungsbeispiel der Erfindung unterscheidet sich von dem zuvor dargestellten zunächst durch das Substratmaterial. Gemäß Fig. 3a wird dabei ausgegangen von einem p-Si Substrat. In dieses Substrat wird gemäß Fig. 3b eine Vertiefung eingebracht, vorzugsweise durch Naß- oder Trockenätzprozesse. Anschließend erfolgt der Aufdampfprozeß des metallischen Materials, wobei vorzugsweise Ti verwendet wird.

Wie in Fig. 3c erkennbar ist, erfolgt hierbei der Kantenabriß für das aufgedampfte Metall an den durch die Vertiefung gebildeten Seitenkanten des Substrats. Hierbei weist das Substrat selbst die Materialeigenschaften auf, die zur Ausbildung der Tunnelbarriere erforderlich sind.

Fig. 3c zeigt eine entsprechend Fig. 2c ausgeführte Gestaltung eines Einzelelektronen-Tunneleffekttransistors.

Das in Fig. 3 dargestellte Verfahren weist gegenüber demjenigen Verfahren, welches in Fig. 2 dargestellt wurde, den Vorteil auf, daß die Strukturierung des bekannten Profils mittels des Ätzprozesses im Bereich der Vertiefung eine höhere Genauigkeit ermöglicht, als die Strukturierung der Kante bei einer Aufdampfung auf ein ebenes Substrat.

In einer besonderen Ausgestaltung des Verfahrens kommt vorzugsweise ein dielektrisches Material im nichtleitenden Bereich zur Anwendung, welches eine poröse Struktur aufweist. Beim anschließenden Aufdampfen der Metallschicht auf den porösen Bereich kann die Schichtdicke des durch die raue Oberfläche unzusammenhängend strukturierten Metallfilms relativ dick gewählt werden, so daß eine wünschenswert hohe Stromdichte im Tunneleffekt-Bauelement erreicht werden kann. Der poröse Untergrund ermöglicht dabei nämlich das Aufbringen relativ dicker unzusammenhängender Metallfilme.

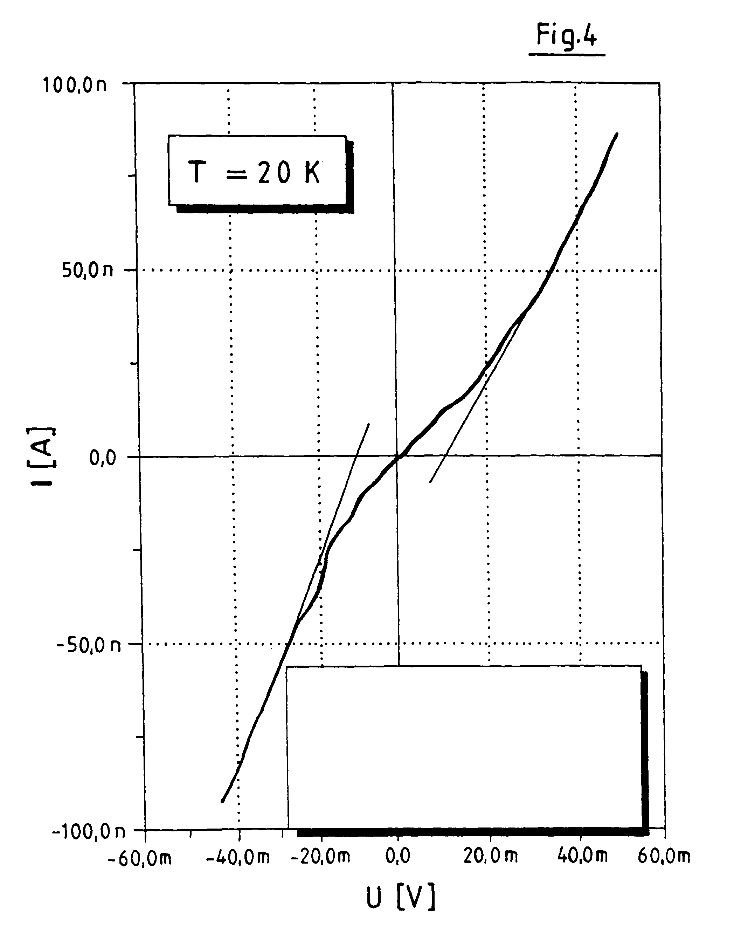

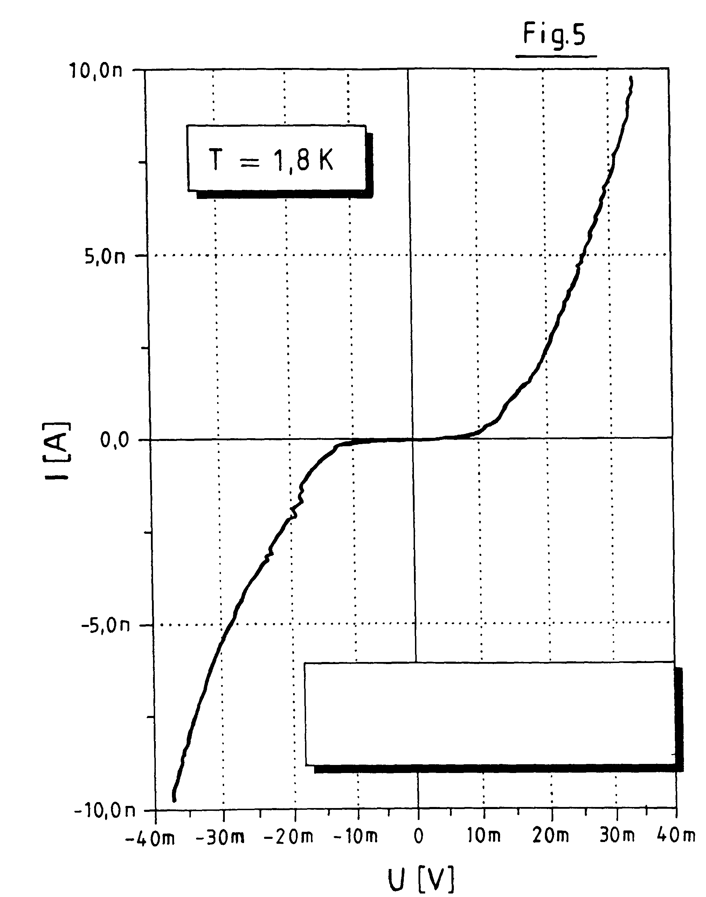

Die in den Fig. 4 und 5 bei einer Temperatur von T=20 bzw. T=1,8 K dargestellten Kennlinien I=f(U) des erfindungsgemäß hergestellten EinzelelektronenTunneltransistors lassen die für das Tunneleffekt-Bauelement typische Coulomb Blockade, bei der sich in einem vergleichsweise großen Spannungsbereich der Strom im Bauelement nur unwesentlich ändert, erkennen.

## Patentansprüche

1. Tunneleffekt-Bauelement bestehend aus

   - einem Substrat (1),

   - einem isolierenden Bereich (2), der aus einer eine Tunnelbarriere bildenden Stufe einer Dicke ($d_2$) auf dem Substrat (1) besteht, wobei mindestens eine ebene Seitenfläche (2a) des stufenförmigen isolierenden Bereichs (2) im wesentlichen senkrecht zur Substratebene verläuft, und

   - einer leitfähigen Schicht (3a,3b) mit einer weiteren Dicke ($d_1$), bestehend aus mindestens zwei leitfähigen Bereichen (3a,3b), die räumlich voneinander durch einen durch Abstimmung der Dicken ($d_1,d_2$) bestimmten, vom leitfähigen Material ausgesparten Abschnitt (2a) der mindestens einen Seitenfläche des isolierenden Bereichs (2) voneinander getrennt sind.

2. Tunneleffekt-Bauelement bestehend aus

   - einem Substrat (1),

   - einem isolierenden Bereich (2), der aus einem eine Tunnelbarriere bildenden porösen Bereich einer Dicke ($d_2$) auf dem Substrat (1) besteht, wobei mindestens eine Seitenfläche (2) des isolierenden porösen Bereichs (2) im wesentlichen senkrecht zur Substratebene verläuft, und

   - einer leitfähigen Schicht (3a,3b) mit einer weiteren Dicke ($d_1$), bestehend aus mindestens zwei leitfähigen Bereichen (3a,3b), die räumlich voneinander durch einen durch Abstimmung der Dicken ($d_1,d_2$) bestimmten, vom leitfähigen Material ausgesparten Abschnitt (2a) der mindestens einen Seitenfläche des isolierenden Bereichs (2) voneinander getrennt sind.

3. Tunneleffekt-Bauelement nach Anspruch 1 oder 2, **dadurch gekennzeichnet**, daß das Substrat (1) im Abschnitt des isolierenden Bereichs (2) eben ist.

4. Tunneleffekt-Bauelement nach einem der Ansprüche 1 bis 3, **dadurch gekennzeichnet**, daß bei abgekantetem Aufdampfprofil der leitfähigen Bereiche (3a,3b) die Materialdicke ($d_1$) des leitfähigen Aufbringungsmaterials kleiner ist als die Länge ($d_2$) der ebenen Seitenfläche.

5. Tunneleffekt-Bauelement nach einem der Ansprüche 1 bis 4, **dadurch gekennzeichnet**, daß dessen aus den leitfähigen Bereichen (3a,3b) und dem isolierenden Bereich gebildete mindestens eine Tunnelkontakt jeweils einen Tunnelwiderstand aufweist, der sehr viel größer ist als der Quantenwiderstand $R_q = h/e^2$.

6. Tunneleffekt-Bauelement nach Anspruch 1, **dadurch gekennzeichnet**, daß das Substrat im Abschnitt des isolierenden Bereichs eine Vertiefung aufweist, wobei das Substratmaterial selbst den isolierenden Bereich des Tunnelkontaktes bildet.

7. Tunneleffekt-Bauelement nach einem der Ansprüche 1-6, **dadurch gekennzeichnet**, daß das Tunneleffekt-Bauelement ein Einzelelektronentunneltransistor ist, bei dem Source und Drain- Anschlüsse mit den beiden leitfähigen Bereichen (3a,3b) verbunden sind und ein weiterer als Gateanschluß ausgeführter leitfähiger Bereich (4) ausgebildet ist, der räumlich benachbart zu einer Inselschicht angeordnet ist, die zwischen den beiden leitfähigen Bereichen (3a,3b) angeordnet ist, wobei die Inselschicht durch Kantenabringe ihres leitfähigen Materials von den beiden leitfähigen Bereichen (3a,3b) isoliert ist.

8. Tunneleffekt-Bauelement nach einem der vorhergehenden Ansprüche, **dadurch gekennzeichnet**, daß die Länge der dem Abschnitt der vom leitfähigen Aufbringungsmaterial ausgesparten Seitenfläche (2a) des isolierenden Bereichs entsprechenden Tunnelstrecke 2-10 nm, insbesondere 8 nm, beträgt.

9. Verfahren zur Herstellung eines Tunnelkontakt-Bauelementes, welches aus mindestens zwei leitfähigen und einem dazwischenliegenden isolierenden Bereich besteht, bei dem auf einen auf der Oberfläche eines Substrats (1) ausgebildeten nichtleitenden Bereich (2) die Aufbringung einer leitfähigen Schicht (3) erfolgt, wobei mindestens zwei voneinander getrennte leitfähige Bereiche ausgebildet werden, die durch Abstimmung der Materialdicken $(d_1,d_2)$ des leitfähigen Aufbringungsmaterials einerseits bzw. des nichtleitenden Materials andererseits von einer im wesentlichen in Aufbringungsrichtung verlaufenden ebenen Seitenfläche (2a) des nichtleitenden Bereichs (2) gegeneinander isoliert sind.

10. Verfahren nach Anspruch 9, **dadurch gekennzeichnet**, daß der nichtleitende Bereich auf die ebene Substratoberfläche aufgebracht wird.

11. Verfahren nach Anspruch 9 oder 10, **dadurch gekennzeichnet**, daß der nicht leitende Bereich durch eine insbesondere durch Ätzen hergestellte Vertiefung in der Substratoberfläche ausgebildet wird.

12. Verfahren nach einem der Ansprüche 9 bis 11, **dadurch gekennzeichnet**, daß im Anschluß an die Aufbringung der leitfähigen Schicht die Herstellung des vom leitfähigen Aufbringungsmaterial ausgesparten Abschnitts (2a) durch Befreiung vom leitfähigen Material erfolgt.

13. Verfahren nach Anspruch 12, **dadurch gekennzeichnet**, daß die Befreiung durch Einspeisung eines kurzfristigen Kurzschlußstroms erfolgt.

14. Verfahren nach Anspruch 12, **dadurch gekennzeichnet**, daß die Befreiung durch einen Ätzprozeß, insbesondere einen Naß- oder Trockenätzprozeß, erfolgt.

15. Verfahren nach Anspruch 12, **dadurch gekennzeichnet**, daß die Befreiung durch eine chemischen Modifikation des leitfähigen Materials, insbesondere Oxidation, Nitrieren, erfolgt.

16. Verfahren nach Anspruch 9-15, **dadurch gekennzeichnet**, daß als Material für den isolierenden Bereich $Cr_2O_3$ und als Material für die leitfähigen Bereiche metallisches Cr verwendet werden.

17. Verfahren nach Anspruch 9-16, **dadurch gekennzeichnet**, daß das Material für den isolierenden Bereich eine poröse Struktur aufweist derart, daß der die mindestens zwei leitfähigen Bereiche (3a,3b) voneinander trennende Abschnitt durch einen Oberflächenbereich der porösen Schicht gebildet wird.

## Claims

1. A tunnel-effect component comprising

   - a substrate (1)

   - an insulating area (2), made from a step forming a tunnel barrier with a thickness (d2) on the substrate (1) whereby at least one flat lateral face (2a) of the step-shaped insulating area (2) essentially is aligned perpendicular to the plane of the substrate, and

   - a conductive layer (3a, 3b) with a further thickness (dl) comprising at least two conductive areas (3a, 3b) which are separated from each other by a section (2a) recessed in the conductive material - depending on the matching of thicknesses $(d_1, d_2)$ - of the lateral face, of which there is at least one, of the insulating area (2).

2. A tunnel effect component comprising

- a substrate (1)

- an insulating area (2), made from a porous area forming a tunnel barrier with a thickness ($d_2$) on the substrate (1) whereby at least one lateral face (2) of the insulating porous area (2) essentially is aligned perpendicular to the plane of the substrate, and

- a conductive layer (3a, 3b) with a further thickness ($d_1$) comprising at least two conductive areas (3a, 3b) which are separated from each other by a section (2a) recessed from the conductive material - depending on the matching of thicknesses ($d_1$, d2) - of the lateral face, of which there is at least one, of the insulating area (2).

3. A tunnel effect component according to claim 1 or 2, **characterized in that** the substrate (1) in the section of the insulating area (2) is flat.

4. A tunnel effect component according to claim 1 to 3, **characterized in that** with an edged deposition profile of the conductive areas (3a, 3b), the material thickness ($d_1$) of the conductive deposition material is less than the length (d2) of the flat lateral face.

5. A tunnel effect component according to claim 1 to 4, **characterized in that** its tunnel contact, of which there is at least one, which is formed by the conductive areas (3a, 3b) and the insulating area, each have a tunnel resistance very much larger than the quantum resistance $Rq = h/e^2$.

6. A tunnel effect component according to claim 1, **characterized in that** the substrate, in the section of the insulating area, has an indentation whereby the substrate material itself forms the insulating area of the tunnel contact.

7. A tunnel effect component according to claim 1 to 6, **characterized in that** the tunnel effect component is a single-electron tunnel transistor in which source and drain connections are connected with the two conductive areas (3a, 3b) and a further conductive area (4), realised as a gate connection, is formed which is located adjacent to an island layer located between the two conductive areas (3a, 3b), whereby the island layer is insulated from the two conductive areas (3a, 3b) by edge breaks of their conductive material.

8. A tunnel effect component according to one of the preceding claims, **characterized in that** the length of the tunnel section - which corresponds to the section of the lateral face (2a) of the insulating area, recessed from the conductive deposition material - is 2-10 nm, in particular 8 nm.

9. A method for producing a tunnel contact component comprising at least two conductive areas and an insulating area located in between, in which on the non-conductive area (2) formed on the surface of a substrate (1), a conductive layer (3) is deposited, whereby at least two conductive areas separate from each other are formed which by matching the material thicknesses ($d_1$, $d_2$) of the conductive deposition material on the one hand, or the non-conductive material on the other hand are insulated from each other by a lateral flat face (2a) of the non-conductive area (2) essentially aligned in the direction of deposition.

10. A method according to claim 9, **characterized in that** the non-conductive area is deposited onto the flat substrate surface.

11. A method according to claim 9 or 10, **characterized in that** the non-conductive area is formed by an indentation in the surface of the substrate, in particular produced by etching.

12. A method according to claim 9 to 11, **characterized in that** after depositing the conductive layer, the recessed section (2a) is produced by freeing the conductive material.

13. A method according to claim 12, **characterized in that** freeing is by supplying a brief short-circuit current.

14. A method according to claim 12, **characterized in that** freeing is by an etching process, in particular by a wet or dry etching process.

15. A method according to claim 12, **characterized in that** freeing is by chemical modification of the conductive material, in particular oxidation, nitration.

16. A method according to claim 9-15, **characterized in that** the material used for the insulating area is $Cr_2O_3$; and the material used for the conductive areas is metallic Cr.

17. A method according to claim 9-16, **characterized in that** the material for the insulating area has a porous structure in such a way that the section separating the conductive areas (3a, 3b) of which there are at least two, is formed by a surface area of the porous layer.

## Revendications

1. Composant à effet tunnel, constitué

   - d'un substrat (1),
   - d'une région isolante (2), qui est constituée d'un gradin d'épaisseur ($d_2$) formant une barrière de tunnel sur le substrat (1), au moins une face latérale plane (2a) de la région isolante (2) en forme de gradin s'étendant sensiblement perpendiculairement au plan du substrat, et
   - d'une couche conductrice (3a, 3b) d'épaisseur différente ($d_1$), constituée d'au moins deux régions conductrices (3a, 3b) qui sont spatialement séparées l'une de l'autre par une partie (2a) d'au moins une face latérale de la région isolante (2), qui est définie par l'harmonisation des épaisseurs ($d_1$, $d_2$) et est évidée du matériau conducteur.

2. Composant à effet tunnel, constitué

   - d'un substrat (1),
   - d'une région isolante (2), qui est constituée d'une région poreuse d'épaisseur ($d_2$) formant une barrière de tunnel sur le substrat (1), au moins une face latérale (2) de la région poreuse isolante (2) s'étendant sensiblement perpendiculairement au plan du substrat, et
   - d'une couche conductrice (3a, 3b) d'épaisseur différente ($d_1$), constituée d'au moins deux régions conductrices (3a, 3b) qui sont spatialement séparées l'une de l'autre par une partie (2a) de la face latérale de la région isolante (2) qui est définie par l'harmonisation des épaisseurs ($d_1$, $d_2$) et évidée du matériau conducteur.

3. Composant à effet tunnel selon la revendication 1 ou 2, caractérisé en ce que le substrat (1) est plan dans ladite partie de la région isolante (2).

4. Composant à effet tunnel selon l'une quelconque des revendications 1 à 3, caractérisé en ce que, avec un profil bordé à vive arête de dépôt sous vide des régions conductrices (3a, 3b), l'épaisseur ($d_1$) du matériau conducteur déposé est inférieure à la longueur ($d_2$) de la face latérale plane.

5. Composant à effet tunnel selon l'une quelconque des revendications 1 à 4, caractérisé en ce que son contact en tunnel respectif, formé des régions conductrices (3a, 3b) et de la région isolante, présente une résistance de tunnel qui est très supérieure à la résistance quantique $R_q = h/e^2$.

6. Composant à effet tunnel selon la revendication 1, caractérisé en ce que le substrat présente un renfoncement dans ladite partie de la région isolante, le matériau du substrat formant lui-même la région isolante du contact en tunnel.

7. Composant à effet tunnel selon l'une quelconque des revendications 1 à 6, caractérisé en ce que le composant à effet tunnel est un transistor tunnel à électron unique, dont les branchements de source et de drain sont reliés aux deux régions conductrices (3a, 3b) et qui prévoit une région conductrice supplémentaire (4), conçue comme branchement de grille, qui est disposée spatialement au voisinage d'une couche en îlot qui est disposée entre les deux régions conductrices (3a, 3b), la couche en îlot étant isolée des deux régions conductrices (3a, 3b) par cassure des arêtes de son matériau conducteur.

8. Composant à effet tunnel selon l'une quelconque des revendications précédentes, caractérisé en ce que la longueur du parcours de tunnel correspondant à ladite partie de la face latérale (2a) de la région isolante qui est évidée du matériau conducteur déposé est égale à 2-10 nm, notamment à 8 nm.

9. Procédé de fabrication d'un composant à effet tunnel qui est constitué d'au moins deux régions conductrices et d'une région isolante intermédiaire, selon lequel on dépose une couche conductrice (3) sur une région non conductrice (2) formée sur la surface d'un substrat (1), au moins deux régions conductrices séparées l'une de l'autre étant formées, régions qui, par harmonisation des épaisseurs respectives ($d_1$, $d_2$) du matériau conducteur déposé et du matériau non conducteur, sont isolées l'une de l'autre par une face latérale plane (2a) de la région non conductrice (2) qui s'étend sensiblement dans la direction de dépôt.

10. Procédé selon la revendication 9, caractérisé en ce que la région non conductrice est déposée sur la surface plane du substrat.

11. Procédé selon la revendication 9 ou 10, caractérisé en ce que la région non conductrice est formée par un renfoncement qui est notamment réalisé par un traitement d'attaque chimique dans la surface du substrat.

12. Procédé selon l'une quelconque des revendications 9 à 11, caractérisé en ce que, à la suite du dépôt de la couche conductrice, on réalise par enlèvement de matériau conducteur la partie (2a) évidée du matériau conducteur déposé.

13. Procédé selon la revendication 12, caractérisé en ce que l'enlèvement s'effectue par alimentation d'un courant temporaire de court-circuit.

**14.** Procédé selon la revendication 12, caractérisé en ce que l'enlèvement s'effectue par un processus d'attaque chimique, notamment par un processus d'attaque chimique à sec ou humide.

**15.** Procédé selon la revendication 12, caractérisé en ce que l'enlèvement s'effectue par une modification chimique du matériau conducteur, notamment par oxydation ou nitrification.

**16.** Procédé selon l'une quelconque des revendications 9 à 15, caractérisé en ce qu'on utilise du $Cr_2O_3$ comme matériau pour la région isolante, et du Cr métallique comme matériau pour les régions conductrices.

**17.** Procédé selon l'une quelconque des revendications 9 à 16, caractérisé en ce que le matériau pour la région isolante présente une structure poreuse de telle sorte que la partie séparant entre elles les deux régions conductrices (3a, 3b) est formée par une région de la surface de la couche poreuse.

Fig.1a

3a

2a

3b

d₁

1

d₂

2

Fig.1b

3a

2a

3b

d₁

d₁

d₂

1

2

Fig.1c

3a

2a

3b

d₁

d₁

d₂

1

2

# Fig.2

(a)

1    Si

(b)    $Cr_2O_3$    2

(c)    Cr

3a    3b

2

4

Gate

2

"Insel"

Source    Drain

3a    3b

Fig.3

a) p - Si

b)

c) Ti
4 — gate
3a
island
drain
source
3b    1

Fig.4

Fig.5

T = 1,8 K